Europäisches Patentamt

European Patent Office

Office européen des brevets

(19)

(11) Veröffentlichungsnummer: **0 013 536**
**A1**

(12) **EUROPÄISCHE PATENTANMELDUNG**

(21) Anmeldenummer: **79810152.3**

(22) Anmeldetag: **15.11.79**

(51) Int. Cl.³: **G 01 R 19/165**

(30) Priorität: **03.01.79 CH 1/79**

(43) Veröffentlichungstag der Anmeldung:
**23.07.80 Patentblatt 80/15**

(84) Benannte Vertragsstaaten:
**AT BE DE FR GB IT NL SE**

(71) Anmelder: **Gilardoni, Angelo**
**Quartiere Ghitello**
**I-6834 Morbio Inferiore(CH)**

(72) Erfinder: **Drixl, Othmar**
**Via Pizzamiglio**
**CH-6833 Vacallo(CH)**

(74) Vertreter: **Baggiolini, Raimondo**
**Racheli & Fiammenghi Via San Gottardo 15**
**CH-6900 Lugano(CH)**

(54) Einrichtung zur Kontrolle des Ladungszustandes einer Batterie in einer Beleuchtungsanlage für Fahrzeuge wie Fahrräder, Kraftfahrzeuge und dergleichen.

(57) Bei einer Einrichtung zur Kontrolle des Ladungszustandes einer Batterie in einer Beleuchungsanlage für Fahrzeuge wie Fahrräder, Kraftfahrzeuge und dergleichen wird eine Leuchtanzeige (12) vorgesehen, wobei die Leuchtanzeige je nach der gewählten Ausführung der Schaltung erlischt oder aufleuchtet, wenn die Spannung der Batterie (13), mit der die Beleuchtungsanlage betrieben wird, unter einem vorzugsweise durch ein Potentiometer (4) einstellbaren unteren Grenzwert sinkt.

Die Erfindung wird vorzugsweise bei Touren- oder Rennfahrrädern angewendet, bei denen eine Batterie automatisch während der Fahrt aufgeladen wird.

EP 0 013 536 A1

Einrichtung zur Kontrolle des Ladungszustandes
einer Batterie in einer Beleuchtungsanlage für
Fahrzeuge wie Fahrräder, Kraftfahrzeuge und dergleichen

Die Erfindung bezieht sich auf eine Einrichtung zur
Kontrolle das Ladungszustandes einer Batterie in
einer Beleuchtungsanlage für Fahrzeuge wie Fahrräder, Kraftfahrzeuge und dergleichen (Mofas, Mopeds,
Lastdreirädern usw.).

Einrichtungen dieser Art sind bekannt. Bei ihnen
wird jedoch der Ladungszustand der Batterie durch
ein Messinstrument, beispielsweise ein Voltmeter,
angezeigt, das den Nachteil hat, dass es während der
Fahrt relativ schwer ablesbar ist. Die schwere Ablesbarkeit kann insbesondere durch Vibrationen des
Fahrzeuges verursacht werden. Ausserdem müssen derartige Messinstrumente nachts beleuchtet werden.

Hier will die Erfindung Abhilfe schaffen. Die Erfindung, wie sie in den Ansprüchen gekennzeichnet
ist, löst die Aufgabe, eine Einrichtung zur Kontrolle des Ladungszustandes einer Batterie in einer Beleuchtungsanlage für Fahrzeuge wie Fahrräder, Kraftfahrzeuge und dergleichen zu schaffen, die dem Fah-

- 2 -

rer das Erreichen der unteren Spannungsgrenze der Batterie unverzüglich anzeigt, bei der die Beleuchtung des Fahrzeuges auf Lasten der Batterie noch für eine kurze Zeit möglich ist, nach deren Ablauf die Batterie entweder aufgeladen oder ersetzt werden muss, je nach dem, ob es sich um eine aufladbare Batterie, einem Akku, oder um ein nicht-aufladbares Element handelt.

Die erfindungsgemässe Einrichtung wird vorzugsweise bei Touren- oder Rennrädern verwendet, bei denen eine Batterie von einem Stromgenerator (Dynamo oder Wechselstromgenerator mit Gleichrichter) speisbar ist, der während der Fahrt angetrieben wird.

Im folgenden wird die Erfindung anhand einer einzigen, lediglich einen Ausführungsweg darstellenden Figur näher erläutert, woraus weitere Vorteile, Einzelheiten und Merkmale der Erfindung hervorgehen.

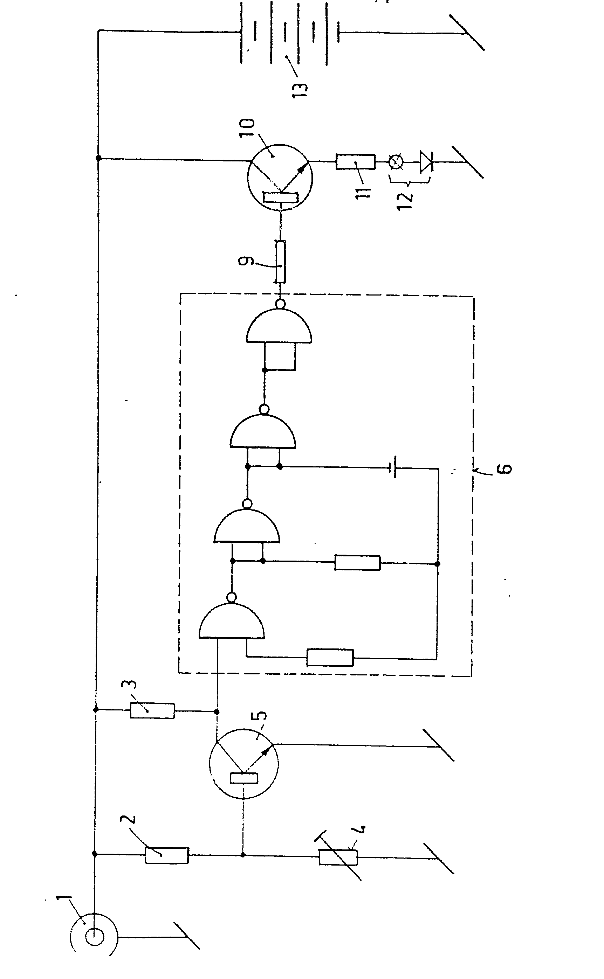

In der Figur ist eine Schaltung für die erfindungsgemässe Einrichtung dargestellt. In der dargestellten Schaltung, die ebenfalls Bestandteil der Erfindung ist, ist mit 1 ein Verbindungsstecker für die Stromzuführung von einem (nicht gezeigten) Generator bezeichnet, und mit 2, 3, 9 und 11 sind Widerstände bezeichnet. Die Transistoren 5 und 10 verstärken die Spannungsschwankungen der Batterie 13 des Fahrzeugs. Ein Potentiometer 4 erlaubt es, den Wert der unteren Grenzspannung einzustellen, bei dem eine Leuchtdiode 12 erlöschen oder aufleuchten soll. Ferner ist ein Flip-Flip-Aggregat 6 vorgesehen, wie gezeigt.

Wie es sich aus der Figur ohne weiteres entnehmen lässt, erlischt die Leuchtdiode 12 (oder leuchtet auf), wenn die Spannung der Batterie 13 mittels des Potentiometers 4 den voreingestellten unteren Grenzwert erreicht. Dadurch wird ein Radfahrer darauf aufmerksam gemacht, dass er den Generator einschalten muss, wenn die Beleuchtungsanlage weiterhin für eine hinreichende Beleuchtung sorgen soll, oder dass er die Batterie auswechseln muss, wenn es sich um ein nicht-aufladbares Element handelt.

Patentansprüche

1. Einrichtung zur Kontrolle des Ladungszustandes einer Batterie in einer Beleuchtungsanlage für Fahrzeuge, wie Fahrräder, Kraftfahrzeuge und dergleichen, gekennzeichnet durch mindestens eine Leuchtanzeige (12) für die Anzeige des Zeitpunktes, zu dem bzw. in dem die Batteriespannung einen vorbestimmten und zuvor eingestellten unteren Grenzwert erreicht.

2. Einrichtung nach Anspruch 1, dadurch gekennzeichnet, dass die Leuchtanzeige von einer Leuchtdiode (12) gebildet ist.

3. Einrichtung nach Anspruch 1 oder 2, dadurch gekennzeichnet, dass der Grenzwert der Spannung der Batterie (13) mittels eines Potentiometers (4) voreinstellbar ist.

4. Einrichtung nach einem der Ansprüche 1 bis 3 für die Verwendung an einem Fahrrad, dadurch gekennzeichnet, dass die Batterie (13) mit einem vom Fahrrad antreibbaren Stromgenerator verbunden ist.

| | EINSCHLÄGIGE DOKUMENTE | | KLASSIFIKATION DER ANMELDUNG (Int.Cl.X) 3 |
|---|---|---|---|
| Kategorie | Kennzeichnung des Dokuments mit Angabe, soweit erforderlich, der maßgeblichen Teile | betrifft Anspruch | |
| | AT - B - 219 706 (SIEMENS) + Seite 2, Zeilen 16-20 + -- DE - A1 - 2 751 836 (BIESINGER) + Fig. 1 + -- FR - A1 - 2 335 063 (SOCIETE ANONYME) + Fig. 1 + -- FR - A1 - 2 306 541 (INTERNATIONAL STANDARD ELECTRIC) + Fig. 1 + -- Das TTL-KOCHBUCH, 1972, München TEXAS INSTRUMENTS DEUTSCHLAND GMBH, Seite 103, Bild 5.28; Seite 108, Bild 5.39 ---- | | G 01 R 19/165 |

**RECHERCHIERTE SACHGEBIETE (Int. Cl.X) 3**

G 01 R 19/00
H 01 M 10/00
B 62 J 5/00

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

X | Der vorliegende Recherchenbericht wurde für alle Patentansprüche erstellt.

| Recherchenort | Abschlußdatum der Recherche | Prüfer |
|---|---|---|
| WIEN | 29-02-1980 | KUNZE |